# EUROPEAN PATENT APPLICATION

(11) **EP 4 104 971 A1**
(43) Date of publication of application: **21.12.2022**
(21) Application number: 21753191.2
(22) Date of filing: 19.01.2021
(51) Int. Cl.: B24B 27/06, B24B 55/06, B24B 55/12, B23Q 1/48, B23Q 11/00, B23Q 3/08, B24B 41/06, H01L 21/301

(54) **MACHINING APPARATUS**

(30) Priority: 10.02.2020 JP 2020020575
(71) Applicant: Towa Corporation, Kyoto-shi, Kyoto 601-8105 (JP)
(72) Inventor: FUKAI, Motoki, Kyoto-shi, Kyoto 601-8105 (JP); HORI, Satoko, Kyoto-shi, Kyoto 601-8105 (JP); SHIRAI, Katsumasa, Kyoto-shi, Kyoto 601-8105 (JP); AZUMA, Hidekazu, Kyoto-shi, Kyoto 601-8105 (JP)
(74) Representative: Müller Hoffmann & Partner
(86) International application number: PCT/JP2021/001709
(87) International publication number: WO 2021/161740

(57) **Abstract**

The present invention aims at eliminating a need for a protective cover such as a bellows cover and improving a collection rate of machining scraps, and includes machining tables 2A and 2B that are fixed at least in X and Y directions on a horizontal plane and hold a workpiece W, a machining mechanism 3 that machines the workpiece W with a rotary tool 30 using a machining liquid, a moving mechanism 5 that linearly moves the machining mechanism 3 at least in each of the X and Y directions on the horizontal plane, and a machining scrap storage unit 9 that is provided below the machining tables 2A and 2B and stores machining scraps S generated by machining by the machining mechanism 3.

## Description

### Technical Field

The present invention relates to a machining apparatus.

### Background Art

Conventionally, a cutting device is used when an electronic component such as a resin-molded substrate is cut into pieces, and for example, a cutting device as shown in Patent Literature 1 is known. The cutting device includes a chuck table that holds a workpiece, and a moving mechanism such as a ball screw that linearly moves the chuck table. In addition, the cutting device includes a protective plate for protecting the moving mechanism from machining scraps generated by cutting or a machining liquid supplied during cutting, and a strainer for catching machining scraps.

The protective plate is configured to be extendable along with the movement of the chuck table, and includes a bellows cover surrounding an upper side and a side of the moving mechanism, and a plurality of plates provided on an upper surface of the bellows cover. In addition, the strainer is provided on a back side or a front side in a movement direction of the moving mechanism in order to catch the machining scraps without hindering movement by the moving mechanism. Then, machining scraps that have dropped from the chuck table and have been placed on an upper surface of the protective plate fall onto the strainer and are caught as the protective plate contracts with the movement of the chuck table.

However, in such a configuration in which the protective plate contracts to catch machining scraps into the strainer as described above, the machining scraps remaining on the upper surface of the protective plate are generated, and it is difficult to improve a collection rate of the machining scraps. In addition, when the chuck table moves in a state where the machining scraps are placed on the upper surface of the protective plate, the machining scraps might enter between the plates overlapped with each other. If the machining scraps enter between the plates, they might not only prevent the expansion and contraction of the protective plate but also contact with the bellows cover and damage the bellows cover. When the bellows cover is damaged, a machining liquid leaks to the moving mechanism to cause rusts to be generated in the moving mechanism, so that malfunction or failure occurs. As a result, it is necessary to frequently perform maintenance work and replacement work for the malfunction or failure, and an operating rate of the cutting device decreases.

### Citation List

### Patent Literature

Patent Literature 1: Japanese Patent No. 6043648

### Summary of Invention

### Technical Problems

Therefore, the present invention has been made to solve the above problems, and a main object thereof is to eliminate a need for a protective cover such as a bellows cover and to improve a collection rate of machining scraps.

### Solution to Problem

Specifically, a machining apparatus according to the present invention includes: a machining table that is fixed at least in X and Y directions on a horizontal plane and holds a workpiece; a machining mechanism that machines the workpiece with a rotary tool while using a machining liquid; a moving mechanism that linearly moves the machining mechanism at least in each of the X and Y directions on the horizontal plane; and a machining scrap storage unit that is provided below the machining table and stores machining scraps generated by machining by the machining mechanism.

### Advantageous Effects of Invention

According to thus configured present invention, it is possible to eliminate a need for a protective cover such as a bellows cover and improve a collection rate of machining scraps.

### Brief Description of Drawings

FIG. 1 is a view schematically illustrating a configuration of a cutting apparatus according to an embodiment of the present invention.
FIG. 2 is a perspective view schematically illustrating a configuration of a substrate cutting module according to the embodiment.
FIG. 3 is a view (plan view) schematically illustrating the configuration of the substrate cutting module according to the embodiment as viewed from a Z direction.
FIG. 4 is a view (side view) schematically illustrating the configuration of the substrate cutting module according to the embodiment as viewed from an X direction.
FIG. 5 is a view (front view) schematically illustrating the configuration of the substrate cutting module according to the embodiment as viewed from a Y direction.
FIG. 6 is a schematic view illustrating an effect of the present embodiment compared with a conventional configuration.
FIG. 7 is a schematic view illustrating an effect of the present embodiment compared with the conventional configuration.

### Reference Signs List

- 100: cutting apparatus (machining apparatus)
- W: molded substrate (workpiece)
- S: machining scraps
- 2A, 2B: cutting table (machining table)
- 3: cutting mechanism (machining mechanism)
- 30: rotary tool
- 31A, 31B: rotary blade
- 32A, 32B: spindle
- 5: moving mechanism
- 51: Y-direction moving unit
- 511: Y-direction guide rail
- 512: support
- 52: X-direction moving unit
- 7A, 7B: vacuum pump
- 9: machining scrap storage unit
- 91X: upper opening
- 91: guide part
- 92: collection container
- 93: separation part

### Mode for Carrying Out Invention

Next, the present invention will be described in more detail with reference to examples. Note that the present invention is not limited by the following description.

As described above, the machining apparatus of the present invention includes: a machining table that is fixed at least in X and Y directions on a horizontal plane and holds a workpiece; a machining mechanism that machines the workpiece with a rotary tool while using a machining liquid; a moving mechanism that linearly moves the machining mechanism at least in each of the X and Y directions on the horizontal plane; and a machining scrap storage unit that is provided below the machining table and stores machining scraps generated by machining by the machining mechanism.

In this machining apparatus, since the machining mechanism moved by the moving mechanism machines the workpiece with respect to the machining table fixed at least in the X and Y directions, a moving mechanism for moving the machining table in the X direction or the Y direction is unnecessary. Therefore, the machining scrap storage unit can be provided below the machining table, and a collection rate of machining scraps can be improved. In addition, it is possible to eliminate a need for a protective cover such as a bellows cover, and it is possible to suppress a decrease in an operating rate of the apparatus due to a damage of the protective cover and to improve productivity of the apparatus.

As a specific embodiment of the machining scrap storage unit, it is desirable that the machining scrap storage unit includes a guide part having an upper opening surrounding the machining table in plan view, and a collection container that collects machining scraps guided by the guide part.

With this configuration, since the guide part has the upper opening surrounding the machining table, collection of machining scraps scattered or dropped from the machining table is hardly missed, resulting in further improving the collection rate of the machining scraps.

It is desirable that the machining scrap storage unit includes a separation part that separates a machining liquid used for machining by the machining mechanism and machining scraps generated by machining by the machining mechanism.

With this configuration, machining scraps can be collected without storing a machining liquid in the collection container. In addition, the separated machining liquid can be reused.

In a case where the machining table is to adsorb and hold the workpiece, a vacuum pump for absorbing and holding the workpiece will be connected to the machining table. Here, since the machining table does not move, the vacuum pump can be provided next to the machining table. Since the vacuum pump can be neared to the machining table, the pipes can be shortened, so that a decrease in an adsorption force due of a pressure loss of the pipe can be prevented.

As a specific arrangement mode of the vacuum pump, it is desirable that two or more of the vacuum pumps are provided along the Y direction corresponding to the two or more machining tables, respectively.

As a specific embodiment of the moving mechanism that moves the machining mechanism at least in the X and Y directions, the moving mechanism may include an X-direction moving unit that linearly moves the machining mechanism in the X direction and a Y-direction moving unit that linearly moves the machining mechanism in the Y direction, and the Y-direction moving unit has a pair of Y-direction guide rails provided along the Y direction with the machining table interposed therebetween, and a support that moves along the pair of Y-direction guide rails and supports the machining mechanism via the X-direction moving unit.

Since the pair of Y-direction guide rails provided in the Y direction is provided so as to sandwich the machining table, a pitch of the pair of Y-direction guide rails can be increased. As a result, influence of a positional deviation in a Z direction between the Y-direction guide rails on machining can be reduced. Specifically, it is possible to reduce a deviation in orthogonality between a rotary tool (for example, the rotary blade) and the machining table, and to improve machining accuracy. In addition, a Y-direction guide rail having a lower specification than a conventional one can be used.

In order to increase a workpiece processing capability in one machining apparatus, two or more of the machining tables may be provided.

In this configuration, the two or more machining tables are desirably provided along the Y direction on the horizontal plane.

With this configuration, since the two or more machining tables are provided along the Y direction, parallelism in the Y direction of the moving mechanism with respect to the two or more machining tables can be adjusted at once. In addition, when a workpiece is processed on one machining table, another processing such as conveyance can be performed on the other machining table.

In order to improve maintainability such as disposal of machining scraps, it is desirable that two or more of the collection containers are provided corresponding to each of the two or more machining tables.

In a case where the machining mechanism is configured to cut the workpiece into pieces with a rotary blade, it is particularly crucial that a cutting direction by the rotary blade and the Y direction of the moving mechanism coincide with each other (i.e., a rotation axis direction of the rotary blade and the Y direction of the moving mechanism are orthogonal to each other.). In the present invention, it is only necessary to position the rotary blade with respect to the support of the Y-direction moving unit, and as compared with a conventional case where a rotation axis direction of a rotary blade is positioned with respect to a machining table that moves independently from the rotary blade, it is easy to position the rotary blade and the machining table.

As a specific embodiment of the machining apparatus of the present invention, it is desirable that the workpiece is a resin-molded substrate, and the machining mechanism is configured to cut the molded substrate into a plurality of products with the rotary blade.

### <One embodiment of the present invention>

In the following, an embodiment of a machining apparatus according to the present invention will be described with reference to the drawings. Note that any of the drawings shown below is schematically illustrated while being omitted or exaggerated as appropriate for easy understanding. The same components are denoted by the same reference numerals, and description thereof will be omitted as appropriate.

### <Overall configuration of machining apparatus>

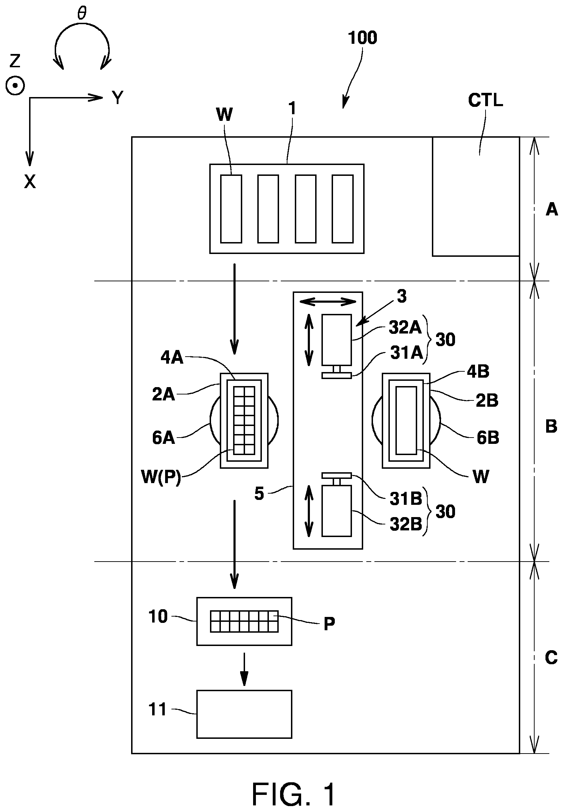

As illustrated in FIG. 1, a machining apparatus 100 of the present embodiment is a cutting apparatus that cuts a molded substrate W, which is a workpiece, into a plurality of products P. The cutting apparatus 100 includes a substrate supply module A, a substrate cutting module B, and an inspection module C as components. Each component (each module A to C) is detachable from and replaceable with another component.

The substrate supply module A supplies the molded substrate W to the substrate cutting module B. Specifically, the substrate supply module A has a substrate supply mechanism 1 for supplying the molded substrate W to the substrate cutting module B. Then, the molded substrate W, which is an object to be cut, is carried out from the substrate supply mechanism 1 and transferred to the substrate cutting module B by a transfer mechanism (not illustrated).

The substrate cutting module B cuts the molded substrate W using a cutting mechanism (machining mechanism) 3 having a rotary tool 30 including a rotary blade and a spindle, and has, for example, a twin spindle configuration of a twin cut table system. Specifically, the substrate cutting module B includes two cutting tables (machining tables) 2A and 2B and two spindles 32A and 32B to which the rotary blades 31A and 31B are attached. A cutting jig 4A is attached to the cutting table 2A, and a cutting jig 4B is attached to the cutting table 2B. A specific configuration of the substrate cutting module B will be described later.

The inspection module C is provided with an inspection table 10. There is placed on the inspection table 10 an aggregate including a plurality of the products P cut into pieces from the molded substrate W. The plurality of products P are inspected by an inspection camera (not illustrated), and are sorted into a non-defective product and a defective product. The non-defective product is stored in a tray 11.

In the present embodiment, a control unit CTL is provided in the substrate supply module A, the control unit performing all operations and controls such as operation of the cutting apparatus 100, conveyance of the molded substrate W, cutting of the molded substrate W, and inspection of the product P. The present invention is not limited thereto, and the control unit CTL may be provided in other module.

### <Specific configuration of substrate cutting module B>

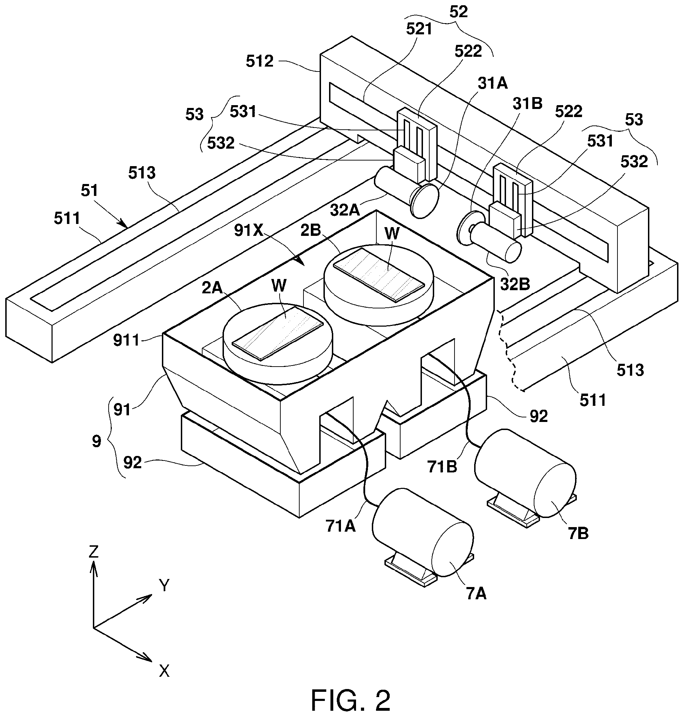

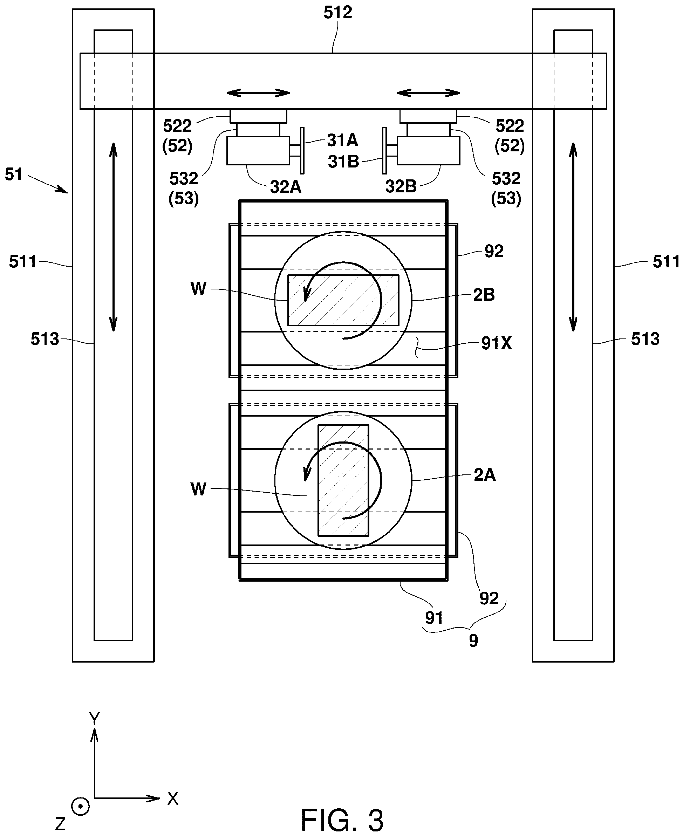

Next, a specific configuration of the substrate cutting module B in the cutting apparatus 100 of the present embodiment will be described below. For convenience, directions orthogonal to each other on a plane (horizontal plane) along the substrate placing surface 21 (holding surface) which is an upper surface of the cutting table 2A, 2B are defined as an X direction and a Y direction, respectively, and a vertical direction orthogonal to the X direction and the Y direction is defined as a Z direction. Specifically, a right-left direction in FIG. 3 is defined as the X direction, and an up-down direction is defined as the Y direction. In FIG. 2, a part of a Y-direction guide rail 511 on the front side is omitted.

As illustrated in FIGS. 2 to 5, the substrate cutting module B includes two cutting tables 2A and 2B that hold the molded substrate W, the cutting mechanism 3 having the two rotary tools 30 including the rotary blades 31A and 31B and the two spindles 32A and 32B, and a moving mechanism 5 that linearly moves the two spindles 32A and 32B of the cutting mechanism 3 in each of the X, Y, and Z directions.

The two cutting tables 2A and 2B are fixed in the X direction, the Y direction, and the Z direction. The cutting table 2A is rotatable in a θ direction by a rotation mechanism 6A provided below the cutting table 2A. Further, the cutting table 2B is rotatable in the θ direction by a rotation mechanism 6B provided under the cutting table 2B.

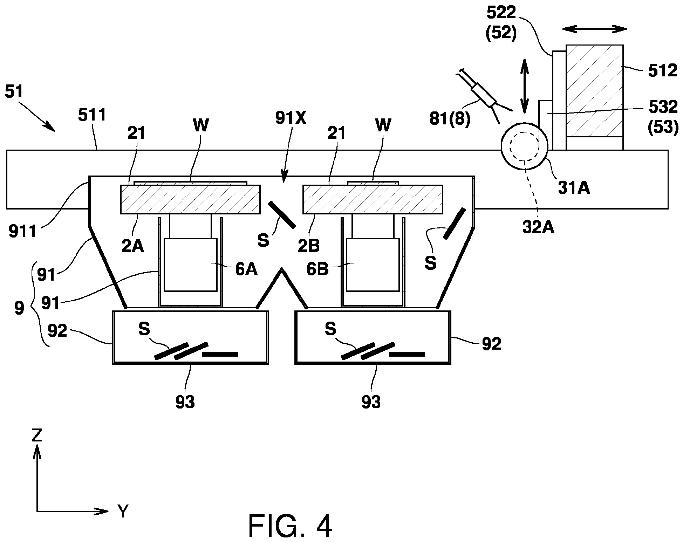

The two cutting tables 2A and 2B are provided along the Y direction on the horizontal plane. Specifically, the two cutting tables 2A and 2B are arranged such that the substrate placing surfaces 21 (holding surfaces), which are the upper surfaces of the cutting tables, are positioned on the same horizontal plane (same height position in the Z direction) (see FIG. 4), and centers (specifically, rotation centers by the rotation mechanisms 6A and 6B) of the substrate placing surfaces 21 are positioned on the same straight line extending in the Y direction (see FIG. 3).

In addition, the two cutting tables 2A and 2B adsorb and hold the molded substrate W, and as illustrated in FIG. 2, two vacuum pumps 7A and 7B for adsorbing and holding the molded substrate are arranged corresponding to the two cutting tables 2A and 2B. Each of the vacuum pumps 7A and 7B is, for example, a liquid-ring vacuum pump, and is provided obliquely below the corresponding cutting tables 2A and 2B along the X direction, and the two vacuum pumps 7A and 7B are provided side by side along the Y direction.

Here, since the cutting tables 2A and 2B are fixed in the X, Y, and Z directions, pipes 71A and 71B connected to the cutting tables 2A and 2B from the vacuum pumps 7A and 7B can be shortened, so that pressure losses of the pipes 71A and 71B can be reduced to prevent a decrease in an adsorption force. As a result, even a very small package of, for example, 1 mm square or less can be reliably adsorbed to the cutting tables 2A and 2B. In addition, since it is possible to prevent a decrease in the adsorption force due to the pressure losses of the pipes 71A and 71B, capacities of the vacuum pumps 7A and 7B can be reduced, leading to cost reduction.

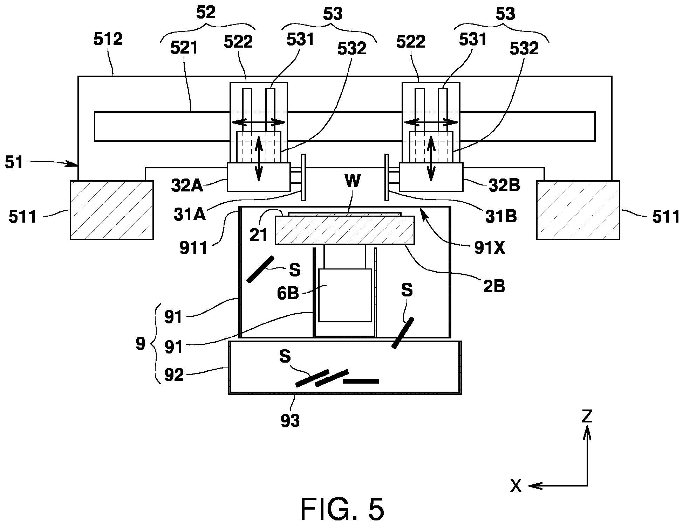

The two spindles 32A and 32B of the cutting mechanism 3 are provided such that rotation axes thereof are along the X direction, and such that the rotary blades 31A and 31B attached thereto are arranged to be opposed to each other (See FIGS. 3 and 5). The rotary blade 31A of the spindle 32A and the rotary blade 31B of the spindle 32B rotate on a plane including the Y direction and the Z direction to cut the molded substrate W held by each of the cutting tables 2A and 2B. As illustrated in FIG. 4, the substrate cutting module B is provided with a liquid supply mechanism 8 having a jet nozzle 81 that jets cutting water (machining liquid) in order to suppress frictional heat generated by the rotary blades 31A and 31B. The jet nozzle 81 is supported by, for example, a Z-direction moving unit 53 to be described later.

As illustrated in FIGS. 2 to 5, the moving mechanism 5 linearly moves each of the two spindles 32A and 32B independently in the X direction, the Y direction, and the Z direction.

Specifically, the moving mechanism 5 includes a Y-direction moving unit 51 that linearly moves the spindles 32A and 32B in the Y direction, an X-direction moving unit 52 that linearly moves the spindles 32A and 32B in the X direction, and a Z-direction moving unit 53 that linearly moves the spindles 32A and 32B in the Z direction.

The Y-direction moving unit 51 is commonly used for the two cutting tables 2A and 2B, and includes a pair of Y-direction guide rails 511 provided along the Y-direction with the two cutting tables 2A and 2B interposed therebetween, and a support 512 that moves along the pair of Y-direction guide rails 511 and supports the spindles 32A and 32B via the X-direction moving unit 52 and the Z-direction moving unit 53. The pair of Y-direction guide rails 511 is provided on the sides of the two cutting tables 2A and 2B provided along the Y direction. Further, the support 512 is, for example, gate-shaped, and has a shape extending in the X direction.

Then, the support 512 linearly reciprocates on the pair of Y-direction guide rails 511 by, for example, a ball screw mechanism 513 extending in the Y direction. The ball screw mechanism 513 is driven by a drive source (not illustrated) such as a servo motor. In addition, the support 512 may be configured to reciprocate by other linear motion mechanism such as a linear motor.

The X-direction moving unit 52 includes an X-direction guide rail 521 provided along the X-direction on the support 512, and an X-direction slider 522 that moves along the X-direction guide rail 521. The X-direction slider 522 is driven by, for example, a linear motor (not illustrated), and linearly reciprocates on the X-direction guide rail 521. In the present embodiment, the two X-direction sliders 522 are provided corresponding to the two spindles 32A and 32B. Accordingly, the two spindles 32A and 32B are movable in the X direction independently of each other. In addition, the X-direction slider 522 may be configured to reciprocate by other linear motion mechanism using a ball screw mechanism.

The Z-direction moving unit 53 includes a Z-direction guide rail 531 provided along the Z-direction in each X-direction slider 522, and a Z-direction slider 532 that moves along the Z-direction guide rail 531 and supports the spindles 32A and 32B. In other words, the Z-direction moving unit 53 is provided corresponding to each of the spindles 32A and 32B. The Z-direction slider 532 is driven by, for example, an eccentric cam mechanism (not illustrated), and linearly reciprocates on the Z-direction guide rail 531. In addition, the Z-direction slider 532 may be configured to reciprocate by other linear motion mechanism such as a ball screw mechanism.

Then, as illustrated in FIGS. 2 to 5, the substrate cutting module B according to the present embodiment further includes a machining scrap storage unit 9 that stores machining scraps S such as cutting scraps generated by cutting the molded substrate W.

The machining scrap storage unit 9 is provided below the cutting tables 2A and 2B, and includes a guide part 91 having an upper opening 91X surrounding the cutting tables 2A and 2B in plan view, and a collection container 92 that collects the machining scraps S guided by the guide part 91.

The guide part 91 guides the machining scraps S scattered or dropped from the cutting tables 2A and 2B to the collection container 92. In the present embodiment, since the upper opening 91X of the guide part 91 is configured to surround the cutting tables 2A and 2B (see FIG. 3), collection of the machining scraps S is hardly missed, resulting in further improving the collection rate of the machining scraps S. The guide part 91 is provided so as to surround the rotation mechanisms 6A and 6B provided under the cutting tables 2A and 2B (see FIG. 4), and is configured to protect the rotation mechanisms 6A and 6B from the machining scraps S and the cutting water.

Although in the present embodiment, the machining scrap storage unit 9 is commonly used for the two cutting tables 2A and 2B, it may be provided corresponding to each of the cutting tables 2A and 2B. In addition, as illustrated in FIGS. 4 and 5, setting a side peripheral wall 911 constituting the upper opening 91X of the guide part 91 at a position higher than the substrate placing surface 21 of the cutting table 2A, 2B allows the machining scraps S to easily enter the guide part 91. The height position of the side peripheral wall 911 constituting the upper opening 91X of the guide part 91 is set to a height position that does not hinder movement of the cutting mechanism 3 such as the spindles 32A and 32B.

The collection container 92 collects the machining scraps S that have passed through the guide part 91 by its own weight, and in the present embodiment, is provided corresponding to each of the two cutting tables 2A and 2B as illustrated in FIG. 4 and the like. The two collection containers 92 are configured to be independently removable from the cutting apparatus 100. With this configuration, maintainability such as disposal of the machining scraps S can be improved. In consideration of a size of the molded substrate W, a size and an amount of the machining scraps S, workability, and the like, one collection container 92 may be provided under the whole cutting table, or three or more collection containers may be provided.

As illustrated in FIG. 4 and the like, the machining scrap storage unit 9 includes a separation part 93 that separates cutting water and machining scraps. As a configuration of the separation part 93, for example, a filter such as a porous plate that allows cutting water to pass through can be provided at a bottom surface of the collection container 92. The cutting water having passed through the filter is returned to the liquid supply mechanism 8 so as to be reused as the cutting water.

Next, an example of operation of the substrate cutting module B will be described.

Cutting on the cutting table 2A is performed by moving the two spindles 32A and 32B in the X, Y, and Z directions by the moving mechanism 5 with respect to the cutting table 2A fixed in the X, Y, and Z directions. For example, after the X-direction moving unit 52 and the Z-direction moving unit 53 fix the spindle 32A at desired positions in the X direction and the Z direction, the Y-direction moving unit 51 moves the spindles 32A and 32B in the Y direction, whereby the molded substrate W is cut along the Y direction. By sequentially performing this operation while shifting the spindle by a predetermined distance in the X direction, the molded substrate W is cut into a plurality of pieces in the X direction. Then, the cutting table 2A is rotated by, for example, 90 degrees in the θ direction by the rotation mechanism 6A, and then, the spindles 32A and 32B are sequentially moved in the Y direction while being shifted by the predetermined distance in the X direction as described above, whereby the plurality of pieces of the molded substrate W are cut along the Y direction. By these operations, the molded substrate W held on the cutting table 2A is cut into a lattice shape so as to be divided into individual pieces.

Similarly to the cutting on the cutting table 2A, cutting on the cutting table 2B is performed by moving the two spindles 32A and 32B in the X, Y, and Z directions by the moving mechanism 5 with respect to the cutting table 2B fixed in the X, Y, and Z directions. For example, after the X-direction moving unit 52 and the Z-direction moving unit 53 fix the spindles 32A and 32B at desired positions in the X direction and the Z direction, the Y-direction moving unit 51 moves the spindles 32A and 32B in the Y direction, whereby the molded substrate W on the cutting table 2B is cut along the Y direction. By sequentially performing this operation while shifting the spindles by the predetermined distance in the X direction, the molded substrate W is cut into a plurality of pieces in the X direction. Then, the cutting table 2B is rotated by, for example, 90 degrees in the θ direction by the rotation mechanism 6B, and then, as described above, the spindles 32A and 32B are sequentially moved in the Y direction while being shifted by the predetermined distance in the X direction, whereby the molded substrate W is cut along the Y direction. By these operations, the molded substrate W held on the cutting table 2B is cut into a lattice shape so as to be divided into individual pieces.

Although in the above operation, the cutting processing on the cutting table 2A and the cutting processing on the cutting table 2B are alternately performed separately, the cutting processing on the cutting table 2A and the cutting processing on the cutting table 2B may be simultaneously performed by moving the spindles 32A and 32B across the cutting table 2A and the cutting table 2B by the Y-direction moving unit 51.

### <Effects of the present embodiment>

According to the cutting apparatus 100 of the present embodiment, since the cutting mechanism 3 (rotary tool 30) moved by the moving mechanism 5 cuts the molded substrate W with respect to the cutting tables 2A and 2B fixed in the X, Y, and Z directions, a moving mechanism that moves the cutting tables 2A and 2B is not required. Therefore, the machining scrap storage unit 9 can be provided below the cutting tables 2A and 2B to enable improvement of a collection rate of the machining scraps S. In addition, it is possible to eliminate a need for a protective cover such as a bellows cover, and it is possible to suppress a decrease in the operating rate of the apparatus due to a damage of the protective cover and to improve productivity of the apparatus.

In the present embodiment, since the guide part 91 of the machining scrap storage unit 9 has the upper opening 91X surrounding the cutting tables 2A and 2B, collection of machining scraps scattered or dropped from the cutting tables 2A and 2B is hardly missed, resulting in further improving the collection rate of the machining scraps S.

In the present embodiment, since the machining scrap storage unit 9 includes the separation part 93 that separates the machining liquid and the machining scraps S, the machining scraps S can be collected without storing the machining liquid in the collection container 92. In addition, the separated machining liquid can be reused.

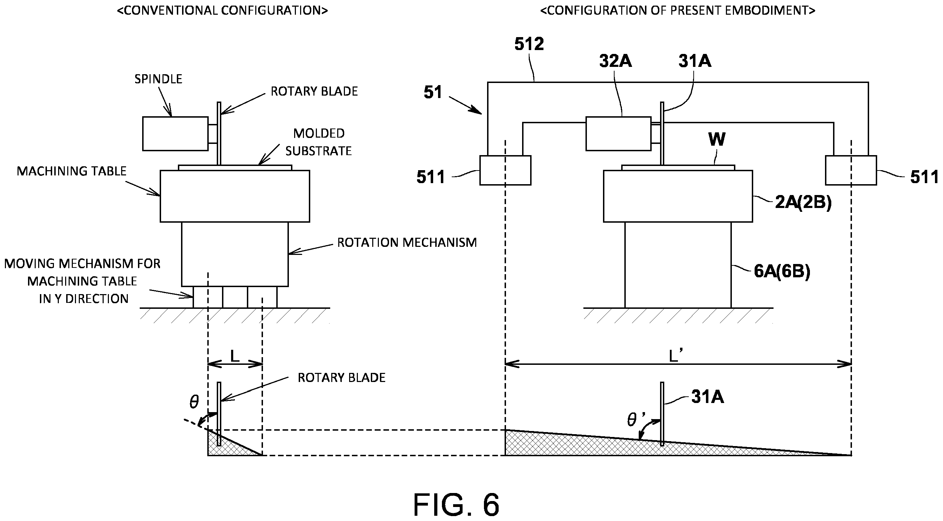

Since in the present embodiment, the pair of Y-direction guide rails 511 provided in the Y direction is provided so as to sandwich the cutting tables 2A and 2B, a pitch of the pair of Y-direction guide rails 511 can be increased. As a result, influence of a positional deviation in the Z direction between the Y-direction guide rails 511 on machining can be reduced. Specifically, as illustrated in FIG. 6, since a pitch L' of the pair of guide rails 511 is larger than a pitch L in a conventional configuration, a deviation in an orthogonality θ between the rotary blade and the rotary table can be reduced. Furthermore, since the pitch between the pair of guide rails 511 is increased, straightness of the Y-direction moving unit 51 is improved, and as a result, cutting edges of the rotary blades 31A and 31B are less shaken, and cutting resistance and the like at the time of cutting are reduced to improve the machining accuracy. In addition, a Y-direction guide rail 511 having a specification lower than a conventional one can be used.

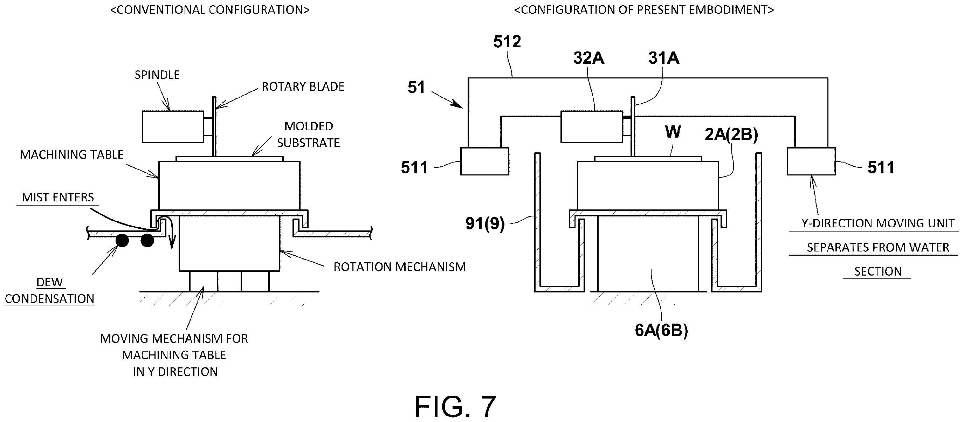

Since in the present embodiment, the Y-direction moving unit 51 (specifically, the Y-direction guide rail 511 and the ball screw mechanism 513) located at the lowest in the moving mechanism 5 is located on the side of the cutting tables 2A and 2B, as illustrated in FIG. 7, the Y-direction moving unit 51 is configured to be separated from the plumbing, which makes it possible to reduce a risk of a failure caused by water in the Y-direction moving unit 51 and to prolong the apparatus life.

In the present embodiment, since two or more of the cutting tables 2A and 2B do not move in the Y direction at the time of cutting, parallelism of the moving mechanism 5 (Y-direction moving unit 51) in the Y direction with respect to the two or more cutting tables 2A and 2B can be adjusted at once. Specifically, in a case where two cutting tables are provided in a conventional apparatus in which the cutting tables move at the time of cutting, it is necessary to adjust parallelism of the two cutting tables in the Y direction and further adjust the adjusted parallelism in the Y direction and parallelism of the rotary blade in the Y direction (specifically, two adjustments are required). In the present embodiment, however, since the two cutting tables 2A and 2B do not move in the Y direction at the time of cutting, it is only necessary to adjust parallelism of the rotary blades 31A and 31B in the Y direction (specifically, one adjustment is sufficient.).

In addition, because of the configuration in which the two or more cutting tables 2A and 2B are provided along the Y direction and the support 512 supporting the spindles 32A and 32B is moved along the Y direction, when the molded substrate W is processed on one cutting table 2A, another processing such as conveyance can be performed on the other cutting table 2B.

### <Other modified embodiments>

Note that the present invention is not limited to the above embodiment.

For example, although in the above embodiment, the description has been made of the cutting apparatus of the twin-cut table system having the twin-spindle configuration, the present invention is not limited thereto, and a cutting apparatus of a single-cut table system having a single-spindle configuration, a cutting apparatus of the single-cut table system having a twin-spindle configuration, or the like are applicable.

Although in the above embodiment, the two cutting tables of the twin-cut table system are provided along the Y direction, a plurality of cutting tables may be provided along the X direction. In this case, the positions of the cutting tables in the Y direction may be the same or may be deviated from each other. In a case where a plurality of cutting tables are provided so as to have positions deviated in the Y direction, by providing a conveyance mechanism capable of accessing each cutting table, it is possible to transport a substrate yet to be cut to the cutting table or carry out the substrate from the cutting table.

In addition, the machining apparatus of the present invention may perform machining other than cutting, and may perform other machining such as cutting and grinding.

In addition, the present invention is not limited to the above embodiment, and it goes without saying that various modifications can be made without departing from the gist of the present invention.

### Industrial Applicability

According to the present invention, it is possible to eliminate a need for a protective cover such as a bellows cover and to improve a collection rate of machining scraps.

## Claims

1. A machining apparatus comprising:
a machining table that is fixed at least in X and Y directions on a horizontal plane and holds a workpiece;
a machining mechanism that machines the workpiece with a rotary tool while using a machining liquid;
a moving mechanism that linearly moves the machining mechanism at least in each of the X and Y directions on the horizontal plane; and
a machining scraps storage unit that is provided below the machining table and stores machining scraps generated by machining by the machining mechanism.

2. The machining apparatus according to claim 1, wherein the machining scrap storage unit includes a guide part having an upper opening surrounding the machining table in plan view, and a collection container that collects machining scraps guided by the guide part.

3. The machining apparatus according to claim 1 or 2, wherein the machining scrap storage unit includes a separation part that separates a machining liquid used for machining by the machining mechanism and machining scraps generated by machining by the machining mechanism.

4. The machining apparatus according to any one of claims 1 to 3, comprising two or more of the machining tables.

5. The machining apparatus according to claim 2, or 3 or 4 depending from claim 2, wherein two or more of the collection containers are provided corresponding to the two or more machining tables, respectively.

6. The machining apparatus according to any one of claims 1 to 5, wherein
the moving mechanism includes an X-direction moving unit that linearly moves the machining mechanism in the X direction and a Y-direction moving unit that linearly moves the machining mechanism in the Y direction, and
the Y-direction moving unit has a pair of Y-direction guide rails provided along the Y direction with the machining table interposed therebetween, and a support that moves along the pair of Y-direction guide rails and supports the machining mechanism via the X-direction moving unit.

7. The machining apparatus according to claim 6 depending from claim 4, wherein the two or more machining tables are provided along the Y direction on the horizontal plane.

8. The machining apparatus according to any one of claims 1 to 7, wherein
the machining table adsorbs and holds the workpiece, and
a vacuum pump for adsorbing and holding the workpiece is provided adjacent to the machining table.

9. The machining apparatus according to claim 8 depending from 7, wherein two or more of the vacuum pumps are provided along the Y direction corresponding to the two or more machining tables, respectively.

10. The machining apparatus according to any one of claims 1 to 9, wherein the machining mechanism is configured to cut the workpiece into pieces with a rotary blade.

11. The machining apparatus according to any one of claims 1 to 10, wherein
the workpiece is a resin-molded substrate, and
the machining mechanism is configured to cut the molded substrate into a plurality of products with the rotary blade.
